(19) Europäisches Patentamt

**European Patent Office**

**Office européen des brevets**

(11) Veröffentlichungsnummer: **0 204 886 B1**

(12) **EUROPÄISCHE PATENTSCHRIFT**

(45) Veröffentlichungstag der Patentschrift: **24.06.92**

(51) Int. Cl.⁵: **H01Q 1/24**, H01Q 9/06

(21) Anmeldenummer: **86101633.5**

(22) Anmeldetag: **08.02.86**

(54) **Antenne für ein Funksende- und empfangsgerät.**

(30) Priorität: **12.06.85 DE 3520983**

(43) Veröffentlichungstag der Anmeldung:
**17.12.86 Patentblatt 86/51**

(45) Bekanntmachung des Hinweises auf die
Patenterteilung:
**24.06.92 Patentblatt 92/26**

(84) Benannte Vertragsstaaten:
**AT BE CH DE FR GB IT LI LU NL SE**

(56) Entgegenhaltungen:
**WO-A-83/03716**
**DE-A- 2 638 888**
**DE-A- 3 302 876**
**US-A- 4 344 184**
**US-A- 4 471 493**

**Funkschau 1989, Heft 22, Funkschau-Spezial,
Seite 12: Franz Beer, "Die richtige Autoantenne für das C-Netz"**

(73) Patentinhaber: **ROBERT BOSCH GMBH
Postfach 30 02 20
W-7000 Stuttgart 30(DE)**

(72) Erfinder: **Gorzel, Heribert, Dipl.-Ing.
Forstweg 33 c
W-1000 Berlin 28(DE)**

(74) Vertreter: **Schmidt, Hans-Ekhardt
Robert Bosch GmbH Geschäftsbereich Elektronik Patent- und Lizenzabteilung Forckenbeckstrasse 9-13
W-1000 Berlin 33(DE)**

## Beschreibung

Stand der Technik

Die Erfindung geht von einer Antenne nach der Gattung des Anspruchs 1 aus.

Es sind schnurlose Telefone bekannt (Funkschau, 1984, Heft 17, Seite 16), bei denen eine Basisstation und ein zugehöriger Handapparat je eine Stabantenne aufweisen. Insbesondere wird bei dem Handapparat eine aus dem Gerätegehäuse herausragende Antenne als störend empfunden. Weiterhin muß bei den bekannten schnurlosen Telefonen eine Antennenweiche vorgesehen sein, damit der Duplex-Betrieb möglich ist. Es ist weiterhin eine Antenne bekannt (DE-A1-33 02 876), bei der die auf einer Leiterplatte befindlichen Leiterbahnen und Leiterflächen sowie die metallischen Bestandteile von elecktrischen Bauelementen und Baueinheiten durch Aufteilung in zwei durch hochohmige Widerstände oder HF-Drosseln überbrückte Bereiche aufgeteilt sind und einen Dipol bilden.

Die Antenne bildet eine Empfangsantenne. Es ist auch eine andere Empfangsantenne bekannt (WO-A1-83/03716), bei der ein gestreckter Dipol aus im Empfängergehäuse angeordneten Drähten besteht. Schließlich ist auch noch eine Mikrowellenantenne bekannt (DE-A1-26 38 888), bei der für ein Sendeteil und ein Empfangsteil je eine Leiterplatte vorgesehen ist und bei der jede Leiterplatte einen Schlitz in ihrer Metallkaschierung enthält. Die Schlitze bilden je eine Schlitzantenne.

Aufgabe

Der Erfindung liegt die Aufgabe zugrunde, eine Antenne gemäß dem Oberbegriff des Anspruchs 1 derart weiterzubilden, daß die Antenne innerhalb des Gerätegehäuses möglichst wenig Platz beansprucht und daß sie dennoch gute Eigenschaften im Sende- und Empfangsbetrieb aufweist und daß ihre Sendeantenne und ihre Empfangsantenne ausreichend voneinander entkoppelt sind.

Lösung

Diese Aufgabe wird bei einer Antenne gemäß dem Oberbegriff des Anspruchs 1 durch die in dem kennzeichnenden Teil dieses Anspruchs angegebenen Merkmale gelöst. Die mit der Erfindung erzielbaren Vorteile bestehen insbesondere darin, daß eine einzige Leiterplatte für die Bidung der Sendeantenne und der Empfangsantenne ausreicht. Ein bevorzugtes Anwendungsgebiet für die Erfindung ist ein schnurloses Telefon.

Durch die in den Unteransprüchen aufgeführten Maßnahmen sind vorteilhafte Weiterbildungen und Verbesserungen der im Anspruch 1 angegebenen Antenne möglich. Besonders vorteilhaft ist eine erfindungsgemäße Antenne, bei der unterhalb oder oberhalb des mittleren Bereiches der Isolierstoffplatte ein HF-Modul angeordnet ist, der einen Hochfrequenzsender und einen Hochfrequenzempfänger enthält und dessen Eingang und Ausgang derart angeordnet sind, daß auf dem kürzesten Wege eine Verbindung zu den Trennebenen Herstellbar ist. Eine Antenne mit diesen Merkmalen eignet sich besonders für einen Handapparat eines schnurlosen Telefons.

Zeichnung

Ausführungsbeispiele der Erfindung sind in der Zeichnung an Hand mehrerer Figuren dargestellt und in der nachfolgenden Beschreibung näher erläutert. Die Zeichnung zeigt in

Fig. 1     eine schematische perspektivische Darstellung einer erfindungsgemäßen Antenne sowie einer Stromverteilungskurve der Antenne für den Sende- und Empfangsbetrieb und

Fig. 2     eine perspektivische, auseinandergezogene Darstellung einer erfindungsgemäßen Antenne mit Kopplungsmitteln und Stromquelle.

Beschreibung der Erfindung

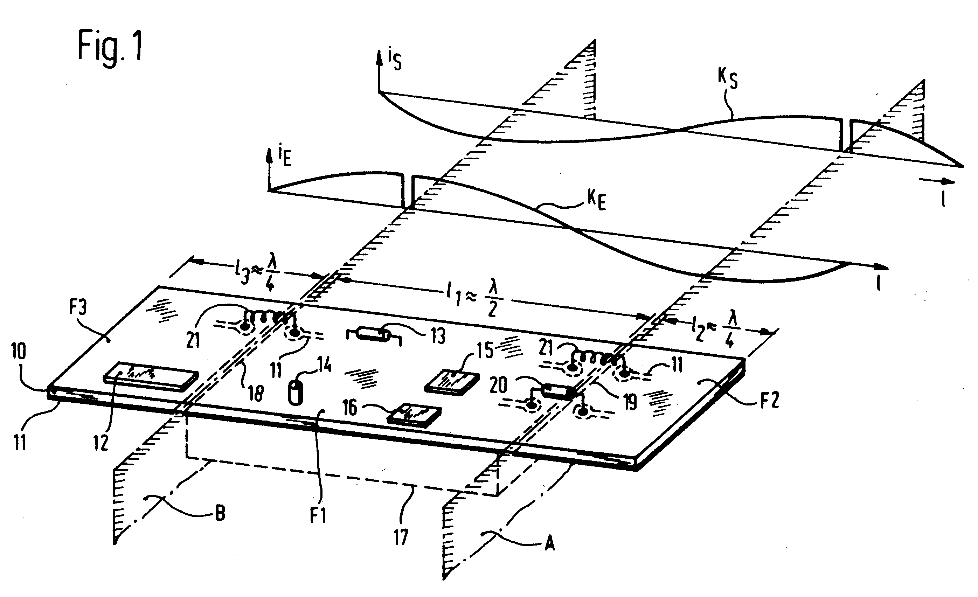

In Fig. 1 bezeichnet 10 eine vorzugsweise kupferkaschierte Isolierstoffplatte, die auf ihrer Unterseite Leitungsbahnen und/oder -flächen 11 aufweist. Auf der Oberseite trägt die Isolierstoffplatte 10 elektrische Bauelemente 12 ... 16. Die Isolierstoffplatte kann gegebenenfalls auch auf der Unterseite mit elektrischen Bauelementen und Bauteilen, zum Beispiel 17, sowie auf der Oberseite mit den entsprechenden Leiterbahnen und Leiterflächen versehen sein. Die mit Leiterbahnen, Leiterflächen, elektrischen Bauelementen und Bauteilen versehene Isolierstoffplatte 10 ist durch zwei Trennebenen A, B in einen mittleren Bereich F1 und zwei seitliche Bereiche F2, F3 aufgeteilt.

Im Bereich der Trennebenen sind die Leiterbahnen und -flächen 11 durch Schlitze 18 und 19 aufgetrennt. Die Bauelemente und Bauteile dürfen allenfalls an die äußere Begrenzung der Schlitze heranreichen; vgl. zum Beispiel das elektrische Bauelement 12. Die elektrische Verbindung zwischen den Bereichen F1, F2, F3 erfolgt über hochohmige Widerstände 20 oder HF-Drosseln 21, so daß die Bereiche hochfrequenzmäßig gegeneinander entkoppelt sind.

Eine Empfangsantenne entsteht dadurch, daß alle leitenden Bestandteile des seitlichen Bereiches F3 einen Strahler bilden, dem als Gegengewicht die Bereiche F1 und F2 mit ihren Bestandteilen aus leitendem Material zugeordnet sind. In analoger Weise wird eine Sendeantenne dadurch gebildet, daß alle metallischen Bestandteile des seitlichen Bereiches F2 einen Strahler bilden, zu dem die leitenden Bestandteile der Bereiche F1 und F3 ein Gegengewicht bilden. Die Längenabmessungen der Bereiche F1, F2, F3 sind vorzugsweise folgende: $l_1 \approx \lambda/2$, $l_2$, $l_3 \approx \lambda/4$. $\lambda$ bedeutet die mittlere Wellenlänge. Für den Empfangsfall ergibt sich eine Stromverteilungskurve $K_E$, die in Fig. 1 oberhalb der Isolierstoffplatte 10 dargestellt ist. Die Stromverteilungskurve zeigt die Abhängigkeit zwischen dem Strom $i_E$ von der Antennenlänge l. Oberhalb der Stromverteilungskurve $K_E$ ist die Stromverteilungskurve $K_S$ für den Sendefall gezeigt.

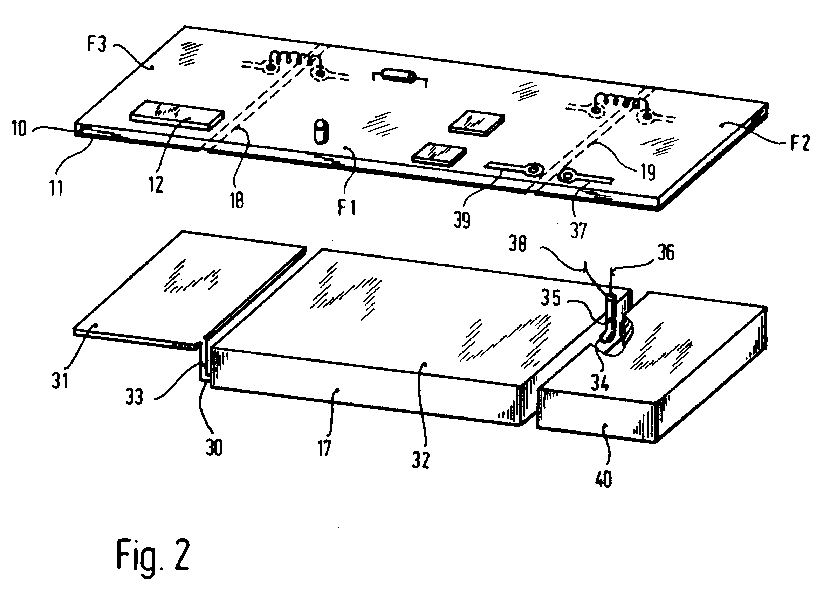

Die Erregung der Sendeantenne und der Empfangsantenne erfolgt in unmittelbarer Nähe der Schlitze 18, 19. Zwei Beispiele für die Erregung sind in Fig. 2 gezeigt. Nach dem Ausführungsbeispiel in Fig. 2 hat das in Fig. 1 mit 17 bezeichnete Bauteil, das zum Beispiel ein Hochfrequenzmodul mit Sende- und Empfangsteil umfaßt, einen Antennenanschluß 30, welcher mit einem kapazitiven Koppelelement 31 verbunden ist. Das Koppelelement besteht vorzugsweise aus einer Isolierstoffolie mit Kupferkaschierung. Die Ebene des Koppelelementes 31 liegt etwa in der Ebene der Oberwand 32 des Bauteils 17. Das Bauteil 17, welches zum Beispiel ein Abschirmgehäuse hat, ist an der Unterseite der Isolierstoffplatte 10 befestigt, wobei zwischen dem Abschirmgehäuse und den Leitungsbahnen und -flächen 11 auf der Unterseite der Isolierstoffplatte 10 zweckmäßigerweise eine Isolierung vorgesehen ist. Ist der Hochfrequenzmodul 17 mit der Isolierstoffplatte 10 mechanisch verbunden, so liegt das Koppelelement 31 in einem geringen Abstand unterhalb der Isolierstoffplatte 10, so daß ein Kondensator gebildet wird, über den die Empfangssignale der Empfangsantenne F3; F1, F2 ausgekoppelt werden. Das kapazitive Koppelelement 31 und dessen Anschlußelement 33 müssen bestimmte geometrische Abmessungen aufweisen, um eine optimale Auskopplung zu erhalten. Das Auskoppeln der an einem Senderausgang 34 liegenden Sendeenergie des Hochfrequenzmoduls 17 kann entweder auch über ein kapazitives Koppelelement oder, wie in Fig. 2 gezeigt, galvanisch über ein Koaxialkabel 35 erfolgen. Der Innenleiter 36 des Koaxialkabels ist mit einer Leiterbahn 37 des seitlichen Bereiches F2 und der Außenleiter 38 mit einer Leiterbahn 39 des mittleren Bereiches F1 verbunden. In Fig. 2 ist noch gezeigt, daß neben dem Hochfrequenzmodul 17 in einem gewissen Abstand von diesem eine Stromquelle 40 angeordnet ist, die somit unterhalb des Bereiches F2 der Isolierstoffplatte 10 liegt. Da die Stromquelle 40, das ist zum Beispiel ein Akkumulator, leitende Teile aufweist, trägt diese zur Bildung der Sendeantenne F2; F1, F3 bei. Die Stromquelle dient zur Stromversorgung des Hochfrequenzmoduls 17 und weiterer elektrischer Bauelemente und Bauteile.

Die bestückte Isolierstoffplatte einschließlich der Koppelelemente und des Hochfrequenzmoduls sind in einem vorzugsweise aus dämpfungsarmem Isolierstoff bestehenden Gehäuse untergebracht, das in den Figuren der Übersichtlichkeit halber weggelassen ist.

**Patentansprüche**

1. Antenne eines Funksende- und -empfangsgerätes, das eine Isolierstoffplatte (10) enthält, die aus einer Metallkaschierung gebildete Leiterbahnen und -flächen (11) aufweist und die als Träger für elektrische Bauelemente und Bauteile dient, dadurch gekennzeichnet, daß die Leiterbahnen und -flächen (11) durch zwei im Bereich zweier senkrecht zu der länglichen Isolierstoffplatte (10) angeordneten Trennebenen (A, B) liegende Schlitze (18, 19) in zwei Endbereiche (F2, F3) und einen dazwischenliegenden mittleren Bereich (F1) aufgeteilt sind, daß die Leiterbahnen an den Schlitzen durch hochohmige Widerstände (20) oder HF-Drosseln (21) überbrückt sind, daß ein erster Endbereich (F2) den Strahler der Sendeantenne für den Hochfrequenzsender und der zweite Endbereich (F3) und der mittlere Bereich (F1) das Gegengewicht zu dem Strahler der Sendeantenne bilden, daß der zweite Endbereich (F3) den Strahler der Empfangsantenne für den Hochfrequenzempfänger und die beiden anderen Bereiche (F1, F2) das Gegengewicht zu dem Strahler der Empfangsantenne bilden und daß die Strahler an den Trennebenen erregt werden und daß dem mittleren Bereich (F1) der Isolierstoffplatte (10) ein den Hochfrequenzsender und Hochfrequenzempfänger enthaltendes HF-Modul (17) zugeordnet ist.

2. Antenne nach Anspruch 1, dadurch gekennzeichnet, daß der Ausgang des Hochfrequenzsenders und der Eingang des Hochfrequenzempfängers derart angeordnet sind, daß auf dem kürzesten Wege eine Verbindung zu den Trennebenen (A, B) herstellbar ist.

3. Antennne nach Anspruch 2, dadurch gekennzeichnet, daß die Leiterbahnen und -flächen (11) der Endbereiche (F2, F3) über ein kapazitives Koppelelement (31) oder galvanisches Koppelelement (35) zur Ankopplung an den HF-Modul (17) angekoppelt sind.

4. Antenne nach Anspruch 3, dadurch gekennzeichnet, daß das kapazitive Koppelelement (31) aus einer Isolierstoffolie mit leitender Oberfläche besteht.

**5.** Antenne nach Anspruch 3, dadurch gekennzeichnet, daß das galvanische Koppelelement (35) ein Koaxialkabel ist.

**6.** Antenne nach Anspruch 1, dadurch gekennzeichnet, daß die Isolierstoffplatte (10) rechtekkig ausgebildet ist und daß der mittlere Bereich (F1) eine Länge $l_1 \approx \lambda/2$ und die beiden seitlichen Bereiche (F2, F3) je eine Länge $l_2$, $l_3$ $\approx \lambda/4$ aufweisen, wobei $\lambda$ die mittlere Betriebswellenlänge ist.

## Claims

**1.** Antenna for a radio transmitter and receiver containing a plate (10) which is made from insulating material, has conductive tracks and surfaces (11) formed by a metal coating and serves as a carrier for electrical components and parts, characterised in that the conductive tracks and surfaces (11) are divided by two slots (18, 19) lying in the region of two planes of separation (A, B) arranged perpendicular to the elongated plate of insulating material (10) into two end regions (F2, F3) and a central region (F1) lying between them, the conductive tracks are bridged over the slots by high-ohm resistors(20) or HF chokes (21), a first end region (F2) forms the emitter of the transmitting antenna for the high-frequency transmitter and the second end region (F3) form the counterpoise to the emitter of the transmitting antenna, the second end region (F3) forms the emitter of the receiving antenna for the high-frequency receiver and the two other regions (F1, F2) form the counterpoise to the emitter of the receiving antenna, the emitters are excited at the planes of separation, and a HF module containing the high-frequency transmitter and high-frequency receiver is associated with the central region (F1) of the plate of insulating material (10).

**2.** Antenna as claimed in claim 1, characterised in that the output of the high-frequency transmitter and the input of the high-frequency receiver are arranged in such a way that a connection to the planes of separation (A, B) can be made by the shortest route.

**3.** Antenna as claimed in claim 2, characterised in that the conductive tracks and surfaces (11) of the end regions (F2, F3) are coupled by a capacitive coupling element (31) or galvanic coupling element (35) for coupling to the HF module (17).

**4.** Antenna as claimed in claim 3, characterised in that the capacitive coupling element (31) consists of a film of insulating material with a conductive surface.

**5.** Antenna as claimed in claim 3, characterised in that the galvanic coupling element (35) is a coaxial cable.

**6.** Antenna as claimed in claim 1, characterised in that the plate (10) made from insulating material is of rectangular construction and that the central region (F1) has a length $l_1 \approx \lambda/2$ and the two side regions (F2), F3) each have a length $l_2$, $l_3 \approx \lambda/4$, $\lambda$ being the mean operating wavelength.

## Revendications

**1.** Antenne d'un appareil radio-émetteur et récepteur, qui contient une carte imprimée (10) en matière isolante qui présente de pistes et des surfaces conductrices (11) formées à partir d'un recouvrement métallique et qui sert de support pour des composants et des constituants électriques, antenne caractérisée en ce que les pistes et les surfaces conductrices (11) sont partagées en deux zones terminales (F2, F3) et une zone médiane (F1) se trouvant entre les deux précédentes, par deux fentes (18, 19) se trouvant dans la zone de deux plans de joint (A, B) disposées perpendiculairement à la carte imprimée longiforme (10) en matière isolante, en ce que les pistes conductrices sont shuntées au niveau des fentes par des résistances (20) à valeur ohmique élevée ou des selfs (21) haute fréquence, en ce qu'une première zone terminale (F2) forme le radiateur de l'antenne émettrice pour l'émetteur à haute fréquence et la deuxième zone terminale (F3) et la zone moyenne (F1) forment le contrepoids au radiateur de l'antenne émettrice, en ce que la deuxième zone terminale (F3) forme le radiateur de l'antenne réceptrice pour le récepteur à haute fréquence et les deux autres zones (F1, F2) forment le contrepoids au radiateur de l'antenne réceptrice et en ce que les radiateurs sont excités au niveau des plans de joint et en ce qu'un module à haute fréquence (17) est associé à la zone moyenne (F1) de la carte imprimée (10) en matière isolante, module qui contient l'émetteur haute fréquence et le récepteur haute fréquence.

**2.** Antenne selon la revendication 1, caractérisée en ce que la sortie de l'émetteur haute fréquence et l'entrée du récepteur haute fréquence sont disposées de telle façon que l'on peut établir une liaison avec les plans de joint (A, B) par le plus court chemin.

**3.** Antenne selon la revendication 2, caractérisée en ce que les postes et les surfaces conductrices (11) des zones terminales (F2, F3) sont couplés par un élément de couplage capacitif (31) ou un élément de couplage galvanique (35) pour l'accouplement du module haute fréquence (17).

**4.** Antenne selon la revendication 3, caractérisée en ce que l'élément de couplage capacitif (31) consiste en une feuille de matière isolante avec une surface conductrice.

**5.** Antenne selon la revendication 3, caractérisée en ce que l'élément de couplage capacitif est un câble coaxial (35).

**6.** Antenne selon la revendication 1, caractérisée en ce que la carte imprimée (10) en matière isolante a une forme rectangulaire et que la zone moyenne (F1) a une longueur $l_1 = \lambda/2$ et les deux zones latérales (F2, F3) ont chacune une longueur $l_2$, $l_3 = \lambda/4$, formules dans lesquelles $\lambda$ est la longueur d'onde moyenne de fonctionnement.

# Fig.1

EP 0 204 886 B1

Fig. 2

EP 0 204 886 B1